# EUROPÄISCHE PATENTANMELDUNG

(11) **EP 2 037 723 A2**
(43) Veröffentlichungstag der Anmeldung: **18.03.2009**
(21) Anmeldenummer: 08164448.6
(22) Anmeldetag: 16.09.2008
(51) Int. Cl.: H05K 3/32

(54) **LED-Kontaktierung**

(30) Priorität: 17.09.2007 DE 102007044340
(71) Anmelder: TridonicAtco Deutschland GmbH, 89231 Neu-Ulm (DE)
(72) Erfinder: Schubert, Gisbert, 89081, Ulm (DE)
(74) Vertreter: Rupp, Christian

(57) **Zusammenfassung**

Eine Basisplatte (21) für ein Leuchtelement (26) insbesondere für die Lichtwerbung weist
- eine erste leitfähige Schicht (23) mit einer ersten Öffnung (32) und eine zweite leitfähige Schicht (24) mit einer zweiten Öffnung (33), und
- eine Isolierschicht (22) zwischen der ersten und der zweiten leitfähigen Schicht (23, 24) auf,

wobei ein erstes Befestigungselement (40) durch die erste Öffnung (32) bzw. ein zweites Befestigungselement (41) durch die zweite Öffnung (33) in die Basisplatte (21) derart einfügbar sind, dass das erste Befestigungselement (40) nur an die zweite leitfähige Schicht (24) bzw. das zweite Befestigungselement (41) nur an die erste leitfähige Schicht (24) elektrisch anschließbar sind.

## Beschreibung

Die vorliegende Erfindung bezieht sich auf einen bspw. für die Lichtwerbung geeigneten Leuchtkörper. Das technische Anwendungsgebiet der Erfindung ist insbesondere das der Leuchtschriften mit Leuchtdioden als Lichtquelle.

Eine Anwendung der Erfindung ist indessen nicht auf die Lichtwerbung beschränkt und bspw. auch in der Allgemeinbeleuchtung denkbar.

Derartige Leuchtkörper werden beispielsweise als Leuchtbuchstaben ausgestaltet und beispielsweise an Gebäudefassaden und Messe- oder Ausstellungs-Ständen angebracht. Dort können sie dann zu Werbezwecken die Form der einzelnen Buchstaben des Namenszuges aufweisen.

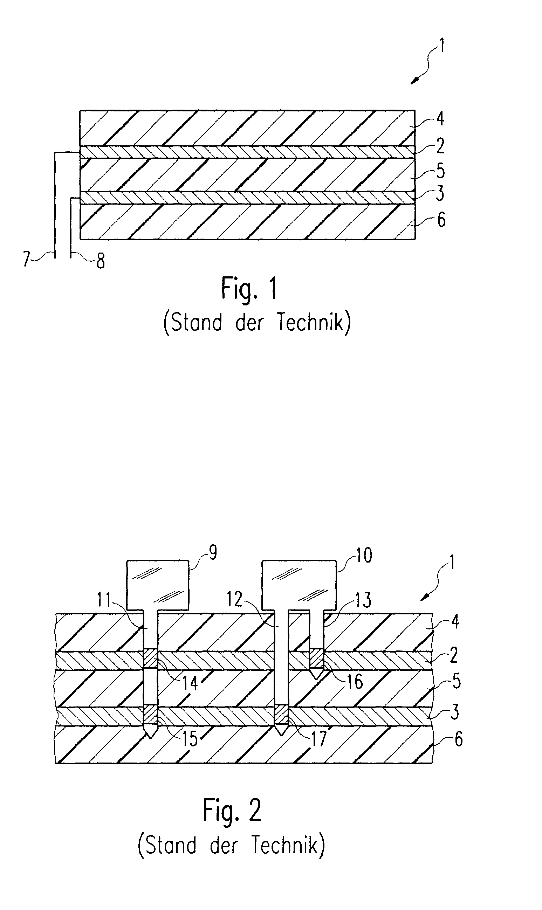

Wie in Fig. 1 gezeigt, sind zum Einsatz in Leuchtbuchstaben Platten 1 mit leitenden Schichten 2, 3 bekannt, wobei in diese Platten 1 gestochene Lampen von den leitenden Schichten 2, 3 über zwei Leitungen 7, 8 mit elektrischer Energie versorgt werden.

Die aus dem Stand der Technik bekannten Platten 1 weisen üblicherweise zwei leitende Schichten 2, 3, wie beispielsweise zwei Metallfolien, und drei Schichten 4, 5, 6 aus einem isolierenden Material auf. Die zwei leitenden Schichten 2, 3 sind zwischen den drei isolierenden Schichten 4, 5, 6 angeordnet, siehe Fig. 1.

In die Platte 1 können Elemente wie beispielsweise Lampen 9, 10 gestochen werden. Um die Verbindung der Lampen 9, 10 zur Platte 1 zu gewährleisten, sind grundsätzlich zwei in Fig. 2 gezeigte Grundkonstruktionen bekannt.

Ein erster möglicher Lampenaufbau 9 zeichnet sich durch einen einzigen Verbindungsstift 11 mit zwei Kontaktzonen 14, 15 aus. Die Kontaktzonen 14, 15 sind auf unterschiedlicher Höhe auf dem Verbindungsstift 11 angebracht, so dass sie nach dem Einstechen der Lampe 9 in die Platte 1 jeweils mit einer leitenden Schicht 2, 3 elektrisch verbunden werden können.

Eine Lampe 10 nach der zweiten Grundkonstruktion kann hingegen zwei Verbindungsstifte 12, 13 mit jeweils einer Kontaktzone 16, 17 zur elektrischen Verbindung mit jeweils einer leitenden Schicht 2, 3 aufweisen.

Die Lampen 9, 10 in Form von beispielsweise Leuchtdioden (LEDs) werden somit einzeln auf der Platte 1 platziert. Die als Zwischenboden dienende Platte 1 wird vorbestückt und anschließend in den Leuchtkörper bzw. in den Leuchtbuchstaben eingelegt.

Nachteilig bei dem Stand der Technik ist aber die Tatsache, dass die Beleuchtung von solchen Leuchtbuchstaben nicht einfach veränderbar ist, da die Platzierung der Leuchtdioden vom Benutzer geändert werden muss.

Es ist demzufolge nicht möglich, die Intensität, die Form oder die Farbe der Gesamtbeleuchtung eines Leuchtbuchstabens schnell zu variieren.

Es ist daher eine Aufgabe der vorliegenden Erfindung, eine Beleuchtung der eingangs genannten Art insbesondere für die Lichtwerbung zu schaffen, die einfach zu montieren ist.

Es ist dementsprechend gemäß der Erfindung eine Möglichkeit gefunden worden, auf eine im wesentlichen kompakte und nicht vorgelöcherte glatte Basisplatte für die Lichtwerbung nun ein mit Leuchtdioden vorbestücktes LED-Modul derart fixieren bzw. anbringen zu können, dass durch diese Fixierung das LED-Modul und die darauf aufgebrachte Leuchtdioden mit der Basisplatte elektrisch verbunden werden bzw. von der Basisplatte mit Strom versorgt werden können.

Erfindungsgemäß ist es insgesamt das erste Mal, dass man für einen Werbungs-Leuchtkörper ein LED-Modul einsetzen kann, statt wie bisher nur einzelne Leuchtdioden.

Der Zwischenboden kann dabei mit einer Kunststoffplatte realisiert werden, die zweiseitig mit Aluminium kaschiert ist. Die Stromzuführung zu den einzelnen LED-Modulen kann über die Alukaschierung bewerkstelligt werden. Dabei bildet eine Kaschierung den Plus- und die andere den Minuspol.

Zwei Blechschrauben pro LED-Modul, eine für den Plus-und eine für den Minuspol, kann die Durchkontaktierung bewerkstelligen. Um einen Kurzschluss zwischen den beiden Polen zu vermeiden, kann die Bohrung für den Pluspol von oben angesenkt werden und für den Minuspol von unten. Die einmalige Stromzuführung pro Platte kann in bekannter Weise mit einer Kabelzuleitung realisiert werden.

Durch die mögliche Kontaktierung von LED-Modulen auf Zwischenplatten ergeben sich folgende Vorteile:
- Ein hoher Freiheitsgrad bei der Platzierung der LED-Lichtpunkte ist nunmehr erreicht.
- Beim einfachen Auswechseln der LED-Module können beispielsweise sehr schnell verschiedene Farben, Leuchtdichten oder Formen für die Leuchtbuchstaben generiert werden.
- Die Fertigstellung eines Leuchtbuchstaben wird beschleunigt, weil die LED-Module mit Leuchtdioden vorbestückt sein können.
- Die einzelne Lichtpunkte müssen nicht manuell platziert werden.
- Die Stromzuführung wird einfacher und sicherer als beim Stand der Technik, weil nur noch ein LED-Module mit der Platte elektrisch verbunden werden muss, statt wie bisher alle Leuchtdioden.
- Die Leuchtdioden werden immer heller, so dass die Anzahl der Lichtpunkte reduziert werden kann, was wiederum mit einem LED-Modul einfacher zu realisieren ist, als mit einer Vielzahl von Leuchtdioden.

Die gestellte Aufgabe wird erfindungsgemäß durch die Merkmale der unabhängigen Ansprüche gelöst. Die abhängigen Ansprüche bilden den zentralen Gedanken der Erfindung in besonders vorteilhafter Weise weiter.

Gemäß einem ersten Aspekt der Erfindung weist eine Basisplatte für ein Leuchtelement insbesondere für die Lichtwerbung, eine erste leitfähige Schicht mit einer ersten Öffnung, eine zweite leitfähige Schicht mit einer zweiten Öffnung und eine Isolierschicht zwischen der ersten und der zweiten leitfähigen Schicht. Ein erstes Befestigungselement bzw. ein zweites Befestigungselement ist derart in die Basisplatte durch die erste Öffnung bzw. durch die zweite Öffnung einfügbar, dass das erste Befestigungselement nur an die zweite leitfähige Schicht bzw. das zweite Befestigungselement nur an die erste leitfähige Schicht elektrisch anschließbar ist.

Die Isolierschicht kann dabei eine Kunststoffplatte sein.

Die erste und die zweite leitfähige Schicht kann ferner aus Aluminium bestehen.

Die Befestigungselemente können insbesondere Blechschrauben sein.

Die Basisplatte kann Leitungen zur Stromversorgung des Leuchtelements aufweisen.

Gemäß einem weiteren Aspekt der Erfindung weist ein Leuchtkörper, insbesondere ein Leuchtbuchstabe für die Lichtwerbung, eine oben definierte Basisplatte auf.

Vorzugsweise kann der Leuchtkörper mindestens ein LED-Modul aufweisen.

Gemäß einem weiteren Aspekt der Erfindung weist ein Leuchtkörper, insbesondere für die Lichtwerbung, eine Basisplatte mit einer Isolierschicht, die zweiseitig mit einer ersten leitfähigen Schicht und einer zweiten leitfähigen Schicht kaschiert ist, und ein mit Leuchtdioden bestücktes LED-Modul auf.

Das LED-Modul kann eine erste Leiterbahn und eine zweite Leiterbahn zum jeweiligen Anschließen an die erste leitfähige Schicht und an die zweite leitfähige Schicht der Basisplatte aufweisen.

Der Leuchtkörper kann vorzugsweise Befestigungselemente aufweisen zur mechanischen Befestigung des LED-Moduls auf der Basisplatte sowie zur Durchkontaktierung der ersten Leiterbahn bzw. der zweiten Leiterbahn des LED-Moduls mit der ersten leitfähigen Schicht bzw. der zweiten leitfähigen Schicht der Basisplatte.

Vorzugsweise kann der Leuchtkörper eine Streuscheibe zur Streuung und Dämpfung des vom LED-Modul generierten Lichts aufweisen.

Weitere Merkmale und Vorteile der Erfindung werden deutlich beim Lesen der folgenden Beschreibung bevorzugter Ausführungsformen, die auf die Zeichnung Bezug nimmt.
- Fig. 1: zeigt eine bekannte Platte für Beleuchtungselemente zum Einsetzen in Leuchtbuchstaben,
- Fig. 2: zeigt bekannte Verbindungen von Beleuchtungselementen mit einer Platte für die Lichtwerbung,
- Fig. 3: zeigt schematisch die Verbindung einer Platte mit einem LED-Modul gemäß der vorliegenden Erfindung, und
- Fig. 4: zeigt ein weiteres Ausführungsbeispiel der Erfindung.

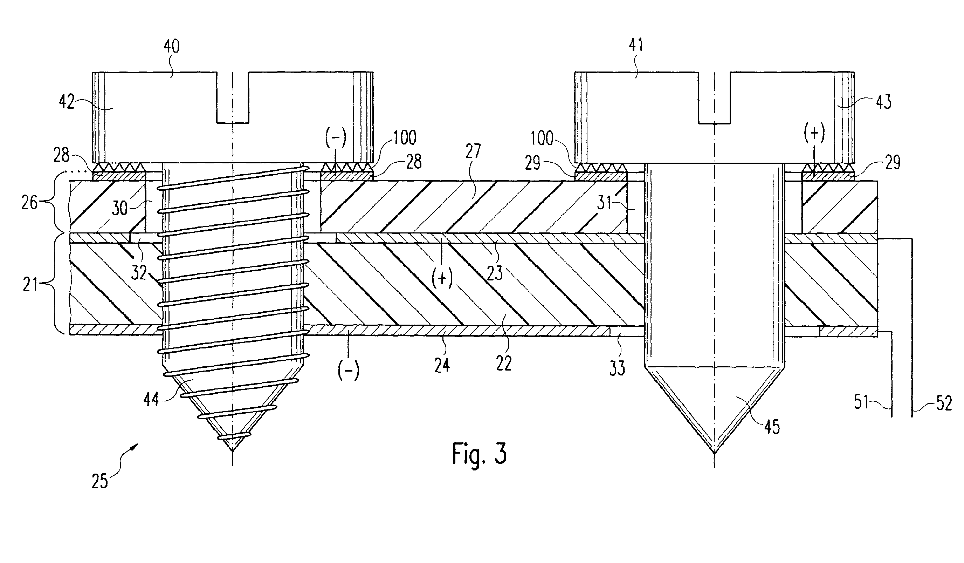

In Fig. 3 ist ein Leuchtkörper 25 für die Lichtwerbung gemäß einem Ausführungsbeispiel der vorliegenden Erfindung gezeigt. Eine Anwendung der Erfindung ist nicht auf die Lichtwerbung beschränkt und bspw. auch in der Allgemeinbeleuchtung etc. denkbar.

Der Leuchtkörper 25 umfasst im Wesentlichen eine Basisplatte 21, ein LED-Modul (oder LED-Array oder Leiterplatte) 26, sowie Schrauben zum Befestigen des LED-Moduls 26 auf der Basisplatte 21.

Das LED-Modul 26 besteht aus einer elektrisch isolierenden Grundplatte 27, worauf eine vorzugsweise dünne Schicht eines leitfähigen Materials wie beispielsweise Kupfer aufgebracht ist. In Fig. 3 ist dieses leitfähige Material in Form einer ersten Leiterbahn 28 und einer zweiten Leiterbahn 29 zu sehen.

Als Material für die Grundplatte 27 kann Kunststoff oder vorzugsweise eine mit Epoxidharz getränkte Glasfasermatte verwendet werden.

Leuchtdioden (oder LEDs für Light Emitting Diode bzw. lichtemittierende Diode) sind in bekannter Weise auf der Grundplatte 27 befestigt und mit der ersten und zweiten Leiterbahn 28, 29 elektrisch verbunden. Die Leuchtdioden können beispielsweise in Serie oder parallel geschaltet werden.

Im LED-Modul 26 sind zwei Öffnungen 30, 31 für Befestigungselemente vorgesehen, insbesondere für Blechschrauben 40, 41 aufweisend einen Kopf 42, 43 und einen mit einem Gewinde versehenen zylindrischen Stift 44, 45. Das LED-Modul 26 kann mit den Blechschrauben 40, 41 fest auf die Basisplatte 21 geschraubt bzw. verbunden werden.

Zwischen den Schrauben und der Leiterbahn können metallisches Zahnscheiben 100 eingelegt sein.

Die Blechschrauben 40, 41 sind ebenso für die elektrische Verbindung zwischen Basisplatte 21 und LED-Modul 26 verantwortlich. Deswegen sind auch zwei Blechschrauben 40, 41 pro LED-Modul 26 notwendig: eine für den Pluspol und eine für den Minuspol.

Das LED-Modul 26 wird auf der Basisplatte 21 fest montiert, indem es darauf verschraubt wird. Der Kopf 42, 43 der Blechschrauben 40, 41 dient als Druckfläche zum Andrücken des LED-Moduls 26 auf die Basisplatte 21.

Erfindungsgemäß drückt dabei der Kopf 42, 43 auf eine Leiterbahn 28, 29, was bereits die elektrische Verbindung von LED-Modul 26 mit Blechschrauben 40, 41 sicherstellt.

Die als Zwischenboden für das LED-Modul 26 benutzte Basisplatte 21 wird mit einer Kunststoffplatte bzw. einer isolierenden Schicht 22 realisiert, die zweiseitig mit Aluminium bzw. leitenden Schichten 23, 24 kaschiert ist.

In der oberen ersten leitenden Schicht 23 ist eine erste Öffnung 32 vorgesehen. Diese erste Öffnung 32 ist breiter als der Durchmesser des Gewindes der Blechschrauben 40, 41.

Erfindungsgemäß wird eine Blechschraube 40 durch diese erste Öffnung 32 in die Basisplatte 21 verschraubt. Dadurch bohrt die Blechschraube 40 ein Loch in die mittlere isolierende Schicht 22 und in die untere zweite leitende Schicht 23. Das Ergebnis ist eine Durchkontaktierung der einen Leiterbahn 28 des LED-Moduls 26 mit der zweiten leitenden Schicht 23, siehe Fig. 3.

Für die zweite Blechschraube 41 ist eine zweite Öffnung 33 in der zweiten leitenden Schicht vorgesehen. Ähnlich wie bei der ersten Blechschraube 40 bohrt sich die zweite Blechschraube 41 durch die erste leitende Schicht 23 und durch die mittlere isolierende Schicht 22, ohne dabei die zweite leitende Schicht 24 zu berühren.

Die erste und die zweite Öffnung 32, 33 dienen also hauptsächlich der Vermeidung eines Kurzschlusses, indem die Blechschrauben 40, 41 jeweils nur an eine leitende Schicht angeschlossen sind.

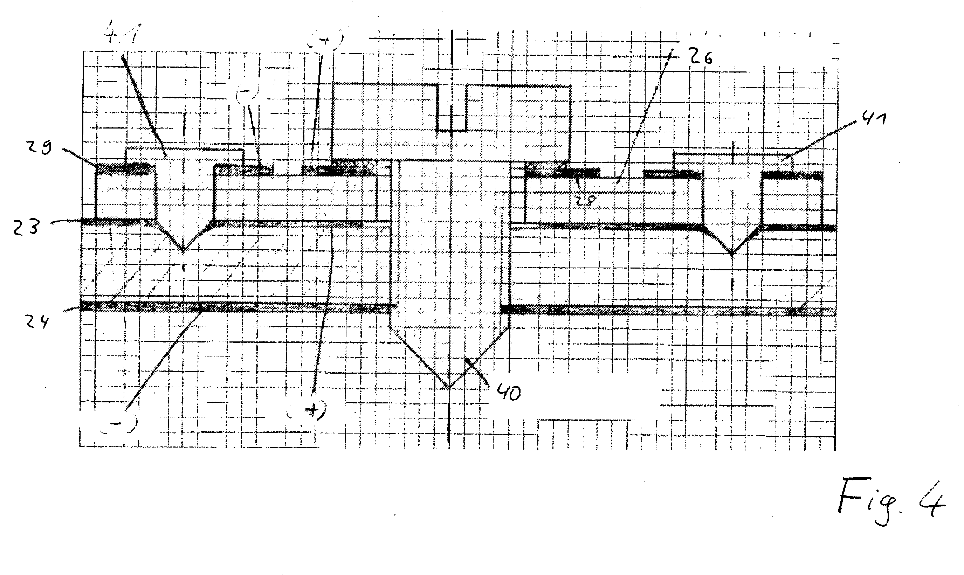

Nunmehr soll ein weiteres Ausführungsbeispiel der Erfindung anhand Figur 4 erläutert werden.

Bei dieser Variante ist das Befestigungselement 41 so ausgeführt, dass seine axiale Erstreckung kürzer ist als die der Blechschraube 40 hat und somit nicht eine Kontaktierung der leitenden Schicht 24 herzustellen kann. Das Befestigungselement 41 kann eine Blechschraube oder ein Stift sein, der durch das LED-Modul 26 hindurchgesteckt wird. Das Befestigungselement 41 hat eine derartige Länge, dass es durch das LED-Modul 26 zumindest soweit hindurchragt, daß es einen elektrischen Kontakt zwischen der Leiterbahn 29 und der leitenden Schicht 23 herstellen kann.

Die LED-Module 26 können entweder bereits Bohrungen aufweisen, die für die Kontaktierung des Befestigungselements 41 vorgesehen sind. Um diese Bohrungen herum existieren für die elektrische Kontaktierung vorbereitete Flächen 29.

Die LED-Module 26 können aber auch für die Kontaktierung vorbereitete Flächen 29 besitzen, durch das Befestigungselement 41 hindurchgepresst werden kann. Dabei wird auch das LED-Modul 26 durchstossen.

Das Befestigungselement 41 kann auch als Schraube ausgeführt sein, die kürzer als die Blechschraube 40 ist. Hinsichtlich ihrer Länge ist nur zu beachten, daß sie ausreichend lang sein muß, um eine Kontaktierung der leitenden Schicht 23 zu ermöglichen, ohne eine Kontaktierung der leitenden Schicht 24 herzustellen.

Durch den Einsatz der im Vergleich zu der Blechschrauben 40 kürzeren Befestigungselements 41 ist eine einfachere Herstellung der Basisplatte 21 möglich. Die Basisplatte 21 muß nur noch auf einer Seite mit einer Öffnung 32 versehen werden. Eine Öffnung 33 ist in diesem Fall nicht notwendig.

Somit kann die Vorbereitung der Basisplatte 21 mit einem Stufenbohrer realisiert werden, der zuerst die Basisplatte 21 durchbohrt und dann die leitenden Schicht 23 kreisförmig entfernt. Damit kann das Setzen der LED-Module 26 auch mit einer Handbohrmaschine vorbereitet werden.

## Patentansprüche

1. Basisplatte (21) für ein Leuchtelement (26) aufweisend
- eine erste leitfähige Schicht (23) mit einer ersten Öffnung (32) und eine zweite leitfähige Schicht (24) mit einer zweiten Öffnung (33), und
- eine Isolierschicht (22) zwischen der ersten und der zweiten leitfähigen Schicht (23, 24),
wobei ein erstes Befestigungselement (40) durch die erste Öffnung (32) bzw. ein zweites Befestigungselement (41) durch die zweite Öffnung (33) in die Basisplatte (21) derart einfügbar sind, dass das erste Befestigungselement (40) nur an die zweite leitfähige Schicht (24) bzw. das zweite Befestigungselement (41) nur an die erste leitfähige Schicht (24) elektrisch anschließbar sind.

2. Basisplatte (21) gemäß Anspruch 1,
wobei die Isolierschicht (22) eine Kunststoffplatte ist.

3. Basisplatte (21) gemäß einem der vorigen Ansprüche,
wobei die erste und die zweite leitfähige Schicht (23, 24) aus Aluminium besteht.

4. Basisplatte (21) gemäß einem der vorigen Ansprüche,
wobei die Befestigungselemente (40, 41) Blechschrauben sind.

5. Basisplatte (21) gemäß einem der vorigen Ansprüche, aufweisend Leitungen (51, 52) zur Stromversorgung des Leuchtelements (26).

6. Basisplatte (21) gemäß einem der vorigen Ansprüche, bei dem das das erste Befestigungselement (40) eine andere, insbesondere eine grössere Länge aufweist als das zweite Befestigungselement (41).

7. Leuchtkörper (25), insbesondere Leuchtbuchstabe für die Lichtwerbung,
aufweisend eine Basisplatte (21) gemäß einem der vorigen Ansprüche.

8. Leuchtkörper (25) gemäß Anspruch 7,
aufweisend mindestens ein LED-Modul (26).

9. Leuchtkörper (25), aufweisend
- eine Basisplatte (21) mit einer Isolierschicht (22), die zweiseitig mit einer ersten leitfähigen Schicht (23) und einer zweiten leitfähigen Schicht (24) kaschiert ist, und
- ein mit Leuchtdioden bestücktes LED-Modul (26).

10. Leuchtkörper (25) gemäß einem der Ansprüche 7 bis 9,
wobei das LED-Modul (26) eine erste Leiterbahn (29) und eine zweite Leiterbahn (28) zum jeweiligen Anschließen an die erste leitfähige Schicht (23) und an die zweite leitfähige Schicht (24) der Basisplatte (21) aufweist.

11. Leuchtkörper (25) gemäß Anspruch 10,
aufweisend Befestigungselemente (40, 41) zur mechanischen Befestigung des LED-Moduls (26) auf der Basisplatte (21) sowie zur Durchkontaktierung der ersten Leiterbahn (29) bzw. der zweiten Leiterbahn (28) des LED-Moduls (26) mit der ersten leitfähigen Schicht (23) bzw. der zweiten leitfähigen Schicht (24) der Basisplatte (21).

12. Leuchtkörper (25) gemäß einem der Ansprüche 7 bis 11,
aufweisend eine Streuscheibe zur Streuung und Dämpfung des vom LED-Modul (26) generierten Lichts.
